**Europäisches Patentamt**

**European Patent Office**

**Office européen des brevets**

(19)

(11) Veröffentlichungsnummer: **0 141 103**

**A1**

(12) **EUROPÄISCHE PATENTANMELDUNG**

(21) Anmeldenummer: **84109925.2**

(22) Anmeldetag: **21.08.84**

(51) Int. Cl.⁴: **C 30 B 15/08**

(30) Priorität: **29.08.83 DE 3331048**

(43) Veröffentlichungstag der Anmeldung:
**15.05.85 Patentblatt 85/20**

(84) Benannte Vertragsstaaten:
**AT BE CH DE FR GB IT LI LU NL SE**

(71) Anmelder: **Marondel, Manfred**
**Grüne Strasse 4**
**D-2863 Ritterhude(DE)**

(72) Erfinder: **Marondel, Manfred**
**Grüne Strasse 4**
**D-2863 Ritterhude(DE)**

(74) Vertreter: **Hoormann, Walter, Dr. et al,**
**FORRESTER & BOEHMERT Widenmayerstrasse 4/I**
**D-8000 München 22(DE)**

(54) Verfahren und Vorrichtung zum Herstellen von insbesondere relativ dünnem plattenförmigen Silizium-Material.

(57) Die Erfindung betrifft ein Verfahren zum Herstellen — insbesondere zur Massenherstellung — von plattenförmigem Silizium-Material, insbesondere relativ geringer Dicke, insbesondere für photovoltaische Energiewandler, bei dem hochreines Silizium unter Schutzgasatmosphäre geschmolzen und unter Überdruck durch eine spaltförmige Öffnung (13) gepreßt wird, das aus der spaltförmigen Öffnung (13) austretende, bandförmige Material (15) gekühlt wird, und von dem gekühlten bandförmigen Material (15) plattenförmige Abschnitte gewünschter Länge abgetrennt werden, wobei die Kühlung mit einer Abkühlgeschwindigkeit von ca. 10⁴ bis 10⁸ K/sec durchgeführt wird, sowie eine Vorrichtung zur Durchführung des Verfahrens, wobei die Kühleinrichtung in an sich bekannter Weise um ihre jeweilige Längsachse drehbare, unter Bildung eines Spaltes mit gegenseitigem Abstand angeordnete Kühlwalzen (7, 7) aufweist, von denen wenigstens eine Kühlwalze (7) angetrieben ist, wobei die Kühlwalzen (7, 7) wenigstens an ihrer Außenseite aus einem Material hoher thermischer Leitfähigkeit bestehen.

EP 0 141 103 A1

Croydon Printing Company Ltd.

Manfred Marondel, Grüne Str. 4, 2863 Ritterhude

---------------------------------------------------------------

Verfahren und Vorrichtung zum Herstellen von insbesondere
relativ dünnem plattenförmigen Silizium-Material

---------------------------------------------------------------

Die Erfindung betrifft ein Verfahren zum Herstellen, insbesondere zur Massenherstellung, von plattenförmigem
Silizium-Material, insbesondere relativ geringer Dicke,
insbesondere für photovoltaische Energiewandler, bei dem
hochreines Silizium unter Schutzgasatmosphäre geschmolzen
und das geschmolzene Silizium unter Überdruck durch eine
spaltförmige Öffnung gepreßt wird, das aus der spaltförmigen Öffnung austretende bandförmige Material gekühlt
wird, und von dem gekühlten bandförmigen Material plattenförmige Abschnitte gewünschter Länge abgetrennt werden.

Die Erfindung betrifft weiterhin eine Vorrichtung zur
Durchführung des vorgenannten Verfahrens mit einem unter

0141103

Schutzgasatmosphäre und Druck zu setzenden, mit einer Heizeinrichtung versehen, temperaturbeständigen Behälter zum Schmelzen von hochreinem Silizium, welcher eine spaltförmige Austrittsöffnung aufweist, der eine Kühleinrichtung zum Kühlen des aus der spaltförmigen Austrittsöffnung austretenden bandförmigen Materials sowie eine Trenneinrichtung zum Trennen des gekühlten bandförmigen Materials in plattenförmige Abschnitte gewünschter Länge und ggf. eine Transportvorrichtung zum Transport der plattenförmigen Siliziumabschnitte zu wenigstens einer Bearbeitungsstation nachgeordnet sind.

Ein derartiges Verfahren und eine Vorrichtung zu dessen Durchführung sind aus der US-PS 4 108 714 bekannt.

Insbesondere seit etwa Mitte der 70er Jahre, also nach der sog. ersten Ölkrise und mit dem seinerzeit verstärkt einsetzenden Umweltbewußtsein, wird verstärkt nach Alternativen zu den klassischen Energiequellen gesucht und – gefördert durch öffentliche und industrielle Forschungsaufwendungen – dabei u.a. auch versucht, die umweltschonende und zukunftsweisende Methode zur Erzeugung elektrischer Energie durch sog. Solartechnik für eine breitere Anwendung wirtschaftlich nutzbar zu machen.

Da diese Technologie als solche auch bereits seinerzeit verhältnismäßig weit fortgeschritten war, bestand und besteht das Hauptziel entsprechender Forschungsvorhaben auf diesem Gebiet in erster Linie in der Verringerung der Produktionskosten für die Herstellung von Solarzellen, und zwar insbesondere der auch als "Wafer" bezeichneten Solarzellen-Rohlinge.

Zwar konnten die Produktionskosten seit etwa 1975 von ca. DM 1250,-- pro Watt auf ca. DM 25,-- pro Watt im Jahr
1982 gesenkt werden, doch werden sich die jetzigen Produktionskosten nach Auffassung der einschlägigen Fachwelt mit den bisher bekannten Herstellungstechnologien
etwa in den kommenden fünf Jahren günstigstensfalls
allenfalls auf DM 5,-- pro Watt senken lassen.

Andere Produktionsverfahren für die Herstellung von Solarzellen bzw. Solarzellen-Rohlingen, wie z.B. die Herstellung
von amorphen Si-Solarzellen durch Aufdampfen eines Si-haltigen Gases auf ein Trägermaterial oder das Ziehen von bandförmigem Si-Material aus einer Schmelze, sind entwicklungsmäßig noch nicht ausgereift. Da es sich bei diesen Verfahren um technologisch sehr anspruchsvolle Herstellungsmethoden handelt, ist zu erwarten, daß sie sich nach angenommener technologischer und wirtschaftlicher Realisierbarkeit zumindest auf absehbare Zeit nur für eine
Produktion kleinerer bis mittlerer Fertigungsmengen eignen,
so daß von diesen noch in der Entwicklung befindlichen
Verfahren keine Alternativen zu dem eingangs genannten
Verfahren für eine Massenproduktion von Si-Wafer zu erwarten ist.

Das konventionelle Verfahren zur Herstellung von Si-Wafer
durch Herstellung von Si-Blöcken, die anschließend (beispielsweise durch Gattersägen od.dgl.) in plattenförmiges Si-Wafer-Material zerlegt werden, ist sehr
material- und arbeitsintensiv, da sich die Kosten von
1 kg Reinst-Silizium, die sich auf ca. DM 200,-- belaufen,
auf ca. DM 1.700,-- für 1 kg Si-Wafer bei Anwendung
dieses konventionellen Verfahrens erhöhen.

Demnach liegt offensichtlich das größte Potential zur
Verminderung der Produktionskosten von Si-Wafer zwischen den Fertigungsschritten "Herstellen von Reinst-Silizium"
und "Weiterverarbeitung der Roh-Wafer", da hier die
Kosten etwa um den Faktor 8 bis 10 und damit annähernd
eine Größenordnung ansteigen.

Das aus der US-PS 4 108 714 bekannte Verfahren der eingangs beschriebenen Gattung sowie die aus dieser Druckschrift bekannte Vorrichtung sind für eine wirtschaftliche Massenproduktion von Si-Wafer befriedigender
Qualität schon deshalb nicht geeignet, weil eine wirtschaftliche Fertigung von Si-Wafer u.a. eine verhältnismäßig hohe Ausstoßleistung erfordert, die mit dem
vorbekannten Verfahren und der hierfür vorgesehenen
Vorrichtung schon deshalb nicht zu erreichen ist, weil
sich mit ihnen lediglich eine mäßige Abkühlgeschwindigkeit erreichen läßt, die eine entsprechend geringe
Ausstoßleistung zur Folge hat, da die aus Silizium oder
Siliziumkarbid bestehenden Walzenmäntel, zwischen welche
das aus dem Schmelzbehälter austretende bandförmige
Silizium-Material gelangt, eine schlechte thermische
Leitfähigkeit besitzt, so daß sich bei der Herstellung
des Si-Bandes zwischen den beiden Walzen aufgrund des
schlechten Wärmeübergangs und der schlechten Wärmeleitung selbst bei intensiver Kühlung der Walzen durch ein
im Bereich der Walzenkerne hindurchgeführtes Kühlmittel
nur eine relativ geringe Wärmemenge aus dem bandförmigen
Si-Material ableiten läßt.

Der vorliegenden Erfindung liegt die Aufgabe zugrunde,
das Verfahren und die Vorrichtung der eingangs beschriebenen Gattungen unter Vermeidung der vorgenannten
und weiterer Nachteile insbesondere dahingehend zu verbessern, daß insbesondere eine kostengünstige Massenproduktion von Si-Wafer für photovoltaische Zwecke mit
großer Ausstoßleistung ermöglicht wird, wobei darüber
hinaus dennoch zugleich eine hohe Qualität des zu
schaffenden plattenförmigen Si-Materials mit für einen
hohen Wirkungsgrad günstiger relativ großer kristalliner
Gitterstruktur erstrebt wird.

Als Lösung des verfahrensmäßigen Teils dieser Aufgabe
ist erfindungsgemäß vorgesehen, daß die Kühlung des aus
der spaltförmigen Öffnung austretenden, bandförmigen
(wenngleich noch nicht festen) Materials mit einer Abkühlgeschwindigkeit von ca. $10^4$ bis $10^9$ K/sec, vorzugsweise etwa $10^6$ bis $10^9$ K/sec durchgeführt wird.

Die Kühlung erfolgt erfindungsgemäß bevorzugt mittels
eines Kühlmaterials hoher thermischer Leitfähigkeit,
welches in bevorzugter Ausgestaltung der vorliegenden
Erfindung aus einem Metall wie insbesondere Kupfer, aber
beispielsweise auch Silber, bestehen kann, wobei das
Kühlmaterial gemäß einer weiteren bevorzugten Ausgestaltung der vorliegenden Erfindung mit dem aus der
spaltförmigen Öffnung austretenden bandförmigen Material
unter Druck in Eingriff gebracht wird, um damit insbesondere den Wärmeübergang zwischen dem (zunächst noch
nicht festen) bandförmigen Si-Material und dem Kühlmaterial
zu intensivieren und hierdurch zugleich auch die hohe
thermische Leitfähigkeit des bevorzugt vorgesehenen
Kühlmaterials ausnutzen zu können, so daß man bei Verwirklichung dieser Maßnahmen ohne Schwierigkeit zu den
weiter oben angegebenen relativ hohen Abkühlgeschwindigkeiten in der Größe bis etwa zu $10^9$ K/sec kommt, die
wiederum entsprechend hohe Durchsatzleistungen
ermöglichen, wobei sich dennoch überraschenderweise
eine im Hinblick auf den

anzustrebenden Wirkungsgrad grobkörnige Struktur
des Si-Wafer erzielen läßt, die keineswegs im mikrokristallinen bzw. amorphen Bereich liegt.

Der vorrichtungsmäßige Teil der obigen Aufgabe wird erfindungsgemäß dadurch gelöst, daß die Kühleinrichtung
in an sich bekannter Weise Kühlwalzen aufweist, die jeweils um ihre Längsachse drehbar sind und unter Bildung
eines Spaltes mit gegenseitigem Abstand zueinander angeordnet sind, wobei die Kühlwalzen wenigstens an ihrer
Außenseite jedoch vorzugsweise vollständig - ggf. mit
Ausnahme eines Hohlkerns zur Aufnahme bzw. zum Durchlaß
von Kühlflüssigkeit - aus einem Material hoher thermischer Leitfähigkeit wie vorzugsweise Kupfer od.dgl. bestehen.

Bevorzugte Ausgestaltungen der Erfindung sind in den
Unteransprüchen beschrieben.

Die Erfindung ist nachstehend an einem Ausführungsbeispiel unter Bezugnahme auf eine schematische Zeichnung
weiter erläutert.

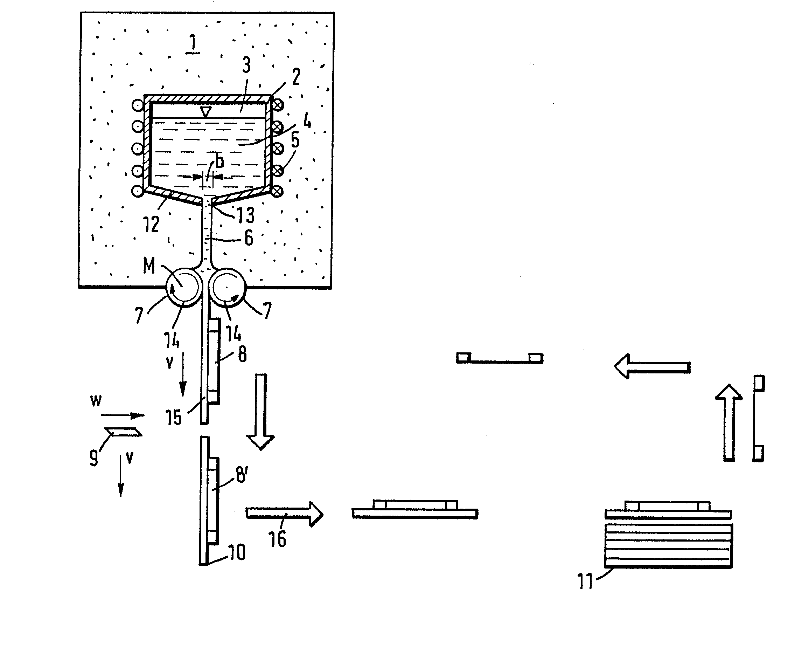

Die Zeichnung zeigt in schematischer Darstellung die
erfindungsgemäße Herstellung von Si-Wafer mittels einer
erfindungsgemäßen Vorrichtung, wobei bei dem Ausführungsbeispiel Si-Wafer einer Breite von 1 m (bei beliebiger
Länge) hergestellt wird.

Die Vorrichtung weist einen Schmelzbehälter 2 aus Quarzglas auf, der eine Länge von 1,2 m und eine Höhe von
0,8 m aufweist und im wesentlichen mit geschmolzenem,
hochreinem Silizium 4 gefüllt ist. Der Behälter 2 ist
zu diesem Zweck mit einer Induktionsspule 5 umgeben, mittels welcher das in festem Zustand in den Behälter 2 gegebene Silizium geschmolzen und damit verflüssigt wird.

Oberhalb des Flüssigkeitsspiegels des flüssigen Siliziums 4 befindet sich ein Schutzgas 3, bei dem es sich beispielsweise um Stickstoff oder um ein Edelgas handeln kann, welches gegenüber der Umgebung unter Überdruck steht. Außerdem ist auch der Behälter 2 von einer Schutzgasatmosphäre 1 umgeben.

An seinem Boden 12 ist der Behälter 2 mittig mit einer spaltförmigen Austrittsöffnung 13 versehen, die eine Breite b von 1 mm und eine in der Zeichnung nicht erkennbare Länge von 1000 mm aufweist und eine Art Schlitzdüse darstellt. Aufgrund des oberhalb des flüssigen Siliziums 4 befindlichen, unter Überdruck stehenden Schutzgases 3 tritt flüssiges Silizium aus der spaltförmigen Austrittsöffnung 13 in Form eines Siliziumfilms 6 nach unten aus, dessen Dicke im wesentlichen der Breite b der Austrittsöffnung 13 ist.

Der Siliziumfilm 6 gelangt innerhalb der den Behälter 2 umgebenden Schutzgasatmosphäre 1 mittig zwischen zwei parallel zur Austrittsöffnung 13 angeordnete Kühlwalzen 7, die jeweils um ihre Längsachse M drehbar und gemäß den Pfeilen 14 gegenläufig antreibbar sind, wobei der gegenseitige Abstand der beiden Kühlwalzen 7 0,7 mm beträgt und damit kleiner ist als die Dicke des aus der Austrittsöffnung 13 des Behälters 2 austretenden Siliziumfilms 6, so daß der noch nicht feste bandförmige Siliziumfilm 6 in innige Berührung mit den beiden Kühlwalzen 7 gelangt und dabei in seiner Dicke vermindert wird.

Bei den Kühlwalzen 7 handelt es sich um Hohlwalzen,
deren Mäntel aus Kupfer bestehen, wobei die in der
schematisierten Zeichnung nicht im einzelnen dargestellten zentrischen Hohlräume von einer Kühlflüssigkeit durchströmt sind. Aufgrund des hervorragenden
Wärmeübergangs zwischen dem heißen, zunächst noch
flüssigen Silizium und den im wesentlichen aus Kupfer
bestehenden Kühlwalzen 7, deren mit dem Silizium in
Berührung kommende Oberflächen durch ein entsprechendes Oberflächenfinish eine hervorragende Oberflächengüte
bzw. eine extrem niedrige Oberflächenrauhigkeit aufweisen, und der außerordentlich hohen thermischen Leitfähigkeit des Kupfers sowie des durch die Walzen
strömenden Kühlmittels kommt es an den Kühlwalzen zu
einer extrem starken Abkühlung des den Walzen zugeführten Siliziumfilms 6 mit einer von den Parametern der
Anlage abhängigen Abkühlgeschwindigkeit von etwa $10^7$
bis $10^8$ K/sec, so daß das aus dem Spalt zwischen den
beiden Kühlwalzen 7 austretende Siliziumband 15 lediglich noch eine Temperatur aufweist, die unterhalb von
$600^\circ$ C liegt und das bandförmige Si-Material nach dem
Verlassen der Walzen 7 mit einer Dicke von 0,7 mm entsprechend verfestigt ist.

Da insbesondere relativ dünnes Band- bzw. plattenförmiges Si-Material relativ spröde und demgemäß relativ
schlecht zu handhaben ist, andererseits aber Verarbeitungsstationen wie einer Trennstation etc. zugeführt
werden muß, gelangt das Siliziumband 15 in den Bereich
einer mit Unterdruck beaufschlagten Haltevorrichtung 8,
die ebenso wie eine in Querrichtung zum Siliziumband 15
mit diesem in Eingriff kommende Diamantsäge 9 mit gleicher Vorschubgeschwindigkeit in Richtung des Pfeiles v
bewegt wird wie das Siliziumband 15, wobei dieses jeweils durch die Diamantsäge 9 in Silizium-Wafer, also plattenförmige Siliziumabschnitte, zerlegt wird, die sodann
mit einer weiteren Unterdruck-Haltevorrichtung 8' gehalten und in Richtung des Pfeils 16 in der Transportrichtung umgelenkt und auf einem Stapel 11 aus Siliziumplatten abgelegt werden, von wo aus sie weiteren Arbeitsstationen beispielsweise zum Dotieren, Kontaktieren etc.
zugeführt und letztlich zu Solarzellen verarbeitet werden. Statt
eines Sägens wäre auch ein Trennen mittels eines Laserstrahls möglich.

Wie bereits oben dargelegt ist, lassen sich mit dem erfindungsgemäßen Verfahren sehr hohe Ausstoßleistungen
erzielen und demgemäß mit relativ geringem Investitionsaufwand sehr schnell hohe Fertigungskapazitäten aufbauen.
Mit einer einzigen Produktionsanlage ließen sich beispielsweise bei einer Produktionsgeschwindigkeit von
ca. 0,3 m/sec und 5000 Betriebsstunden pro Jahr ca.
8850 t Silizium zu Si-Solarzellen außerordentlich kostengünstig verarbeiten, was in etwa $5,4 \times 10^6$ m$^2$ Solarzellen oder einer installierten Leistung von ca. 500 Megawatt entspricht.

Es ist erkennbar, daß die Rentabilität einer solchen
Produktionsanlage durch die entsprechende Preissituation
ohne weiteres gegeben ist. Dabei sind die gemäß dem
Ausführungsbeispiel hergestellten Si-Solarzellen mit
einer Dicke von 0,7 mm etwa doppelt so dick wie die bisher für erdgebundene Zwecke hergestellten Si-Solarzellen
und damit entsprechend formstabiler, wobei indes der
Materialaufwand der gleiche ist, da hier im Gegensatz zu
dem oben beschriebenen konventionellen Verfahren keine
Sägeverluste anfallen, die bei dem konventionellen Herstellungsverfahren etwa 40 bis 50 % des eingesetzten
Materials ausmachen. Wenn man dagegen auf die erhöhte Festigkeit der Si-Wafer verzichten und diese etwa in gleicher Stärke wie die bisher üblichen Solarzellen (0,3 bis 0,5 mm) herstellen will, so erhält mithin gegenüber dem konventionellen Verfahren eine Materialeinsparung in der Größenordnung von ca. 50 % des eingesetzten Rohmaterials. Darüber hinaus entfallen bei dem erfindungsgemäßen Verfahren gegenüber dem konventionellen Verfahren u.a. das Gießen des Siliziums in Blockformen, das Zuschneiden der Siliziumblöcke, das Trennen der Si-Blöcke in Si-Wafer, die hierfür erforderlichen Trenneinrichtungen und Trennwerkzeuge, der für das Trennen erforderliche Arbeitsaufwand, das Reinigen der nach dem Trennen erhaltenen Si-Wafer von beim Trennen eingesetzten Kühl- und Schmiermitteln etc..

Des weiteren ist davon auszugehen, daß die Dotier-, Kontaktier-, Beschichtungs- und Montagekosten bei größeren Wafern degressiv sinken, wie sie beispielsweise bei einer Wafergröße von 1 m$^2$ gegeben sind.

Insgesamt lassen sich mithin die Herstellungskosten pro Watt photovoltaischer Energiewandler auf Si-Basis um den Faktor 8 bis 10 und damit um etwa eine Größenordnung senken, was bezogen auf die heutigen Produktionskosten von ca. DM 20,-- pro Watt zu Herstellungskosten von ca. DM 2,-- pro Watt und weniger führt. Damit kommen aber photovoltaische Energiewandler auf Si-Basis in außerordentlich wirtschaftliche Bereiche, so daß man ohne Übertreibung unter diesen Umständen von einer konkurrenzlosen Erzeugung elektrischer Energie bezüglich der Wirtschaftlichkeit reden kann, da sie im Gegensatz zu konventionellen Stromerzeugungsanlagen ohne entsprechende Kosten verursachende Energieträger arbeiten, wobei noch hinzukommt, daß es sich bei der Entnahme

0141103

von Sonnenenergie um die umweltfreundlichste und -er-
haltenste Energieentnahme handeln dürfte.

BEZUGSZEICHENLISTE
(LIST OF REFERENCE NUMERALS)

| | | |
|---|---|---|
| 1 | Schutzgas | 1 |
| 2 | (Schmelz-)Behälter | 2 |
| 3 | Schutzgas (in 2; unter Überdruck stehend) | 3 |
| 4 | flüssiges Silizium | 4 |
| 5 | Induktionsspule (um 2) | 5 |
| 6 | Siliziumfilm | 6 |
| 7 | Kühlwalzen | 7 |
| 8, 8' | (Unterdruck-)Haltevorrichtung | 8 |
| 9 | Diamantsäge | 9 |
| 10 | abgetrennte Siliziumplatten ("Silizium-Wafer") | 10 |
| 11 | Stapel aus Siliziumplatten | 11 |
| 12 | Boden (von 2) | 12 |
| 13 | Austrittsöffnung | 13 |
| 14 | Pfeile | 14 |
| 15 | Siliziumband | 15 |
| 16 | Pfeil | 16 |
| 17 | | 17 |
| 18 | | 18 |
| 19 | | 19 |
| 20 | | 20 |
| 21 | | 21 |
| 22 | | 22 |
| 23 | | 23 |
| 24 | | 24 |
| 25 | | 25 |
| 26 | | 26 |
| 27 | | 27 |
| 28 | | 28 |
| 29 | | 29 |
| 30 | | 30 |

A n s p r ü c h e
==================

1. Verfahren zum Herstellen - insbesondere zur Massenherstellung - von plattenförmigem Silizium-Material,
insbesondere relativ geringer Dicke, insbesondere für
photovoltaische Energiewandler, bei dem hochreines
Silizium unter Schutzgasatmosphäre geschmolzen und unter
Überdruck durch eine spaltförmige Öffnung gepreßt wird,
das aus der spaltförmigen Öffnung austretende, bandförmige Material gekühlt wird, und von dem gekühlten
bandförmigen Material plattenförmige Abschnitte gewünschter Länge abgetrennt werden, dadurch gekennzeichnet, daß die Kühlung mit einer Abkühlgeschwindigkeit von
ca. $10^4$ bis $10^9$ K/sec durchgeführt wird.

2. Verfahren nach Anspruch 1, dadurch gekennzeichnet,
daß die Abkühlgeschwindigkeit ca. $10^6$ bis $10^9$ K/sec
beträgt.

3. Verfahren nach Anspruch 1 oder 2, dadurch gekennzeichnet, daß die Kühlung mittels eines Kühlmaterials
hoher thermischer Leitfähigkeit durchgeführt wird.

4. Verfahren nach Anspruch 3, dadurch gekennzeichnet,

512

daß die Kühlung mittels eines metallenen Kühlmaterials
durchgeführt wird.

5. Verfahren nach Anspruch 4, dadurch gekennzeichnet,
daß das Kühlmaterial aus Kupfer oder Silber besteht.

6. Verfahren nach einem oder mehreren der Ansprüche
3 bis 5, dadurch gekennzeichnet, daß das Kühlmaterial
mit dem aus der spaltförmigen Öffnung austretenden bandförmigen Material unter Druck in Eingriff gebracht wird.

7. Verfahren nach einem oder mehreren der vorhergehenden
Ansprüche, dadurch gekennzeichnet, daß das Schmelzen in
einem Behälter aus Quarzglas, Keramik od.dgl. erfolgt.

8. Verfahren nach einem oder mehreren der vorhergehenden
Ansprüche, dadurch gekennzeichnet, daß das Schmelzen
induktiv erfolgt.

9. Verfahren nach einem oder mehreren der vorhergehenden
Ansprüche, dadurch gekennzeichnet, daß die Dicke des
aus der spaltförmigen Öffnung austretenden bandförmigen
Materials beim Kühlen verringert wird.

10. Verfahren nach Anspruch 9, dadurch gekennzeichnet,
daß die Dicke des aus der spaltförmigen Öffnung austretenden bandförmigen Materials beim Kühlen auf einen
Wert von ca. 0,1 bis 1,0 mm verringert wird.

11. Verfahren nach Anspruch 10, dadurch gekennzeichnet,
daß die Dicke des aus der spaltförmigen Öffnung austretenden bandförmigen Materials beim Kühlen auf einen
Wert von ca. 0,3 bis 0,7 mm verringert wird.

0141103

12. Verfahren nach einem oder mehreren der vorhergehenden
Ansprüche, dadurch gekennzeichnet, daß das abschnittsweise Zerlegen des bandförmigen Materials durch Sägen
oder durch einen Laserstrahl erfolgt.

13. Vorrichtung zum Herstellen, insbesondere zur Massenherstellung, von plattenförmigen Silizium-Material, insbesondere relativ geringer Dicke, insbesondere für
voltaische Energiewandler, zur Durchführung des Verfahrens nach einem oder mehreren der vorhergehenden
Ansprüche, mit einem unter Schutzgas und Druck zu setzenden,
mit einer Heizeinrichtung versehenen, temperaturbeständigen
Behälter zum Schmelzen von hochreinem Silizium, welcher
eine spaltförmige Austrittsöffnung aufweist, der eine
Kühleinrichtung zum Kühlen des aus der Austrittsöffnung
austretenden bandförmigen Materials sowie eine Trenneinrichtung zum Trennen des gekühlten bandförmigen Materials
in plattenförmige Abschnitte gewünschter Länge und ggf.
eine Transportvorrichtung zum Transport der plattenförmigen Siliziumabschnitte zu wenigstens einer Bearbeitungsstation nachgeordnet sind, dadurch gekennzeichnet,
daß die Kühleinrichtung in an sich bekannter Weise um
ihre jeweilige Längsachse drehbare, unter Bildung eines
Spaltes mit gegenseitigem Abstand angeordnete Kühlwalzen
(7, 7) aufweist, von denen wenigstens eine Kühlwalze (7)
angetrieben ist, wobei die Kühlwalzen (7, 7) wenigstens
an ihrer Außenseite aus einem Material hoher thermischer
Leitfähigkeit bestehen.

14. Vorrichtung nach Anspruch 13, dadurch gekennzeichnet,
daß die Kühlwalzen vollständig aus einem Material hoher
thermischer Leitfähigkeit bestehen.

15. Vorrichtung nach Anspruch 14, dadurch gekennzeichnet, daß die Kühlwalzen (7, 7) aus Kupfer oder Silber bestehen.

16. Vorrichtung nach einem oder mehreren der Ansprüche 13 bis 15, dadurch gekennzeichnet, daß die Kühlwalzen (7, 7) hohl ausgebildet sind und von einem Kühlmittel durchströmt sind.

17. Vorrichtung nach einem oder mehreren der Ansprüche 13 bis 16, dadurch gekennzeichnet, daß der Behälter (2) aus Quarglas, Keramik od.dgl. besteht.

18. Vorrichtung nach einem oder mehreren der Ansprüche 13 bis 17, dadurch gekennzeichnet, daß der Behälter (2) mit einer Induktionsheizung (5) zu beheizen ist.

19. Vorrichtung nach Anspruch 18, dadurch gekennzeichnet, daß der Behälter (2) von wenigstens einer Induktionsspule (5) umgeben ist.

20. Vorrichtung nach einem oder mehreren der Ansprüche 13 bis 19, dadurch gekennzeichnet, daß die Kühlwalzen (7, 7) gegenläufig rotieren.

21. Vorrichtung nach Anspruch 20, dadurch gekennzeichnet, daß beide Kühlwalzen (7, 7) angetrieben sind.

22. Vorrichtung nach einem mehreren der Ansprüche 13 - 21, dadurch gekennzeichnet, daß die Oberfläche der Kühlwalzen (7, 7) mit einem Feinfinish versehen ist.

23. Vorrichtung nach einem mehreren der Ansprüche 13 - 22, dadurch gekennzeichnet, daß das aus dem Walzenspalt austretende bandförmige Material beim Transport und/oder Bearbeiten (beispielsweise beim Zerlegen) mittels einer Unterdruck-Haltevorrichtung (8; 8') zu halten ist.

24. Vorrichtung nach Anspruch 23, dadurch gekennzeichnet, daß die Unterdruck-Haltevorrichtung (8; 8') mitlaufend ausgebildet ist.

25. Vorrichtung nach einem oder mehreren der Ansprüche 13 bis 24, dadurch gekennzeichnet, daß der gegenseitige Abstand der Kühlwalzen (7, 7) veränderbar ist.

26. Vorrichtung nach einem oder mehreren der Ansprüche 13 bis 25, dadurch gekennzeichnet, daß die Trenneinrichtung eine Diamantsäge aufweist.

27. Vorrichtung nach einem oder mehreren der Ansprüche 13 bis 25, dadurch gekennzeichnet, daß die Trenneinrichtung eine Lasereinrichtung aufweist.

1/1

1 · 2 · 3 · 4 · 5 · 6 · 7 · 8 · 9 · 10 · 12 · 13 · 14 · 15 · 16 · M · b · v · w

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | JAPANESE JOURNAL OF APPLIED PHYSICS, Band 19, Suppl. 19-1, 1980, Seiten 655-658, Tokyo, JP; N. TSUYA et al.: "Polycrystalline silicon ribbons made by rapid quenching methods" * Seiten 656,657; Figur 3 * | 1,3,4, 6-10, 13,14, 17-20 | C 30 B  15/08 |

----- 

**RECHERCHIERTE SACHGEBIETE (Int. Cl.4)**

C 30 B   15/08
C 30 B   11/00
C 30 B   29/60

Der vorliegende Recherchenbericht wurde für alle Patentansprüche erstellt.

| Recherchenort | Abschlußdatum der Recherche | Prüfer |
|---|---|---|
| DEN HAAG | 19-12-1984 | BRACKE P.P.J.L. |

EPA Form 1503 03 82